Europäisches Patentamt

European Patent Office

Office européen des brevets

(19)

(11) **EP 0 865 610 B1**

(12) **EUROPÄISCHE PATENTSCHRIFT**

(45) Veröffentlichungstag und Bekanntmachung des Hinweises auf die Patenterteilung:
**08.03.2000 Patentblatt 2000/10**

(51) Int Cl.$^7$: **G01R 33/032**

(21) Anmeldenummer: **96945748.0**

(22) Anmeldetag: **22.11.1996**

(86) Internationale Anmeldenummer:
**PCT/DE96/02248**

(87) Internationale Veröffentlichungsnummer:
**WO 97/21108 (12.06.1997 Gazette 1997/25)**

(54) **OPTISCHES MESSVERFAHREN UND OPTISCHE MESSVORRICHTUNG ZUM MESSEN EINES MAGNETISCHEN WECHSELFELDES MIT INTENSITÄTSNORMIERUNG**

OPTICAL MEASUREMENT METHOD AND OPTICAL MEASUREMENT DEVICE FOR MEASURING AN ALTERNATING MAGNETIC FIELD WITH INTENSITY NORMALIZATION

PROCEDE ET DISPOSITIF DE MESURE OPTIQUE POUR MESURER UN CHAMP ALTERNATIF MAGNETIQUE AVEC NORMALISATION D'INTENSITE

(84) Benannte Vertragsstaaten:
**CH DE FR GB IT LI**

(30) Priorität: **07.12.1995 DE 19545759**

(43) Veröffentlichungstag der Anmeldung:
**23.09.1998 Patentblatt 1998/39**

(73) Patentinhaber: **SIEMENS AKTIENGESELLSCHAFT
80333 München (DE)**

(72) Erfinder:
• **WILLSCH, Michael
D-90762 Fürth (DE)**

• **BOSSELMANN, Thomas
D-91054 Erlangen (DE)**
• **HAIN, Stefan
D-91090 Effeltrich (DE)**

(56) Entgegenhaltungen:
**EP-A- 0 557 090        WO-A-92/13280
US-A- 4 916 387**

• **SENSORS AND ACTUATORS A, Bd. A47, Nr. 1/03, 1.März 1995, Seiten 487-490, XP000516312 HOLM U ET AL: "TRANSMISSION LOSS COMPENSATION FOR FARADAY EFFECT FIBRE OPTIC SENSORS"**

EP 0 865 610 B1

**Beschreibung**

Die Erfindung betrifft ein Verfahren und eine Anordnung zum Messen eines magnetischen Wechselfeldes. Unter einem magnetischen Wechselfeld wird dabei und im folgenden ein Magnetfeld verstanden, das nur von Null verschiedene Frequenzanteile in seinem Frequenzspektrum aufweist und somit insbesondere zeitlich veränderlich ist.

Es sind optische Meßanordnungen und Meßverfahren zum Messen eines Magnetfeldes unter Ausnutzung des magnetooptischen Faraday-Effekts bekannt. Unter dem Faraday-Effekt versteht man die Drehung der Polarisationsebene von linear polarisiertem Licht in Abhängigkeit von einem Magnetfeld. Der Drehwinkel ist proportional zum Wegintegral über das Magnetfeld entlang des von dem Licht zurückgelegten Weges mit der sogenannten Verdet-Konstanten als Proportionalitätskonstante. Die Verdet-Konstante ist im allgemeinen material-, temperatur- und wellenlängenabhängig. Zum Messen des Magnetfeldes wird eine Faraday-Sensoreinrichtung aus einem optisch transparenten Material wie beispielsweise Glas in dem Magnetfeld angeordnet. Das Magnetfeld bewirkt eine Drehung der Polarisationsebene von durch die Faraday-Sensoreinrichtung gesendetem linear polarisiertem Licht um einen Drehwinkel, die für ein Meßsignal ausgewertet werden kann. Eine bekannte Anwendung finden solche magnetooptischen Meßverfahren und Meßanordnungen beim Messen elektrischer Ströme. Die Faraday-Sensoreinrichtung wird dazu in der Nähe eines Stromleiters angeordnet und erfaßt das von einem Strom in dem Stromleiter erzeugte Magnetfeld. Im allgemeinen umgibt die Faraday-Sensoreinrichtung den Stromleiter, so daß das Meßlicht den Stromleiter in einem geschlossenen Weg umläuft. Der Betrag des Drehwinkels ist in diesem Fall direkt proportional zur Amplitude des zu messenden Stromes. Die Faraday-Sensoreinrichtung kann als massiver Glasring um den Stromleiter ausgebildet sein oder auch den Stromleiter in Form einer Meßwicklung aus einer lichtleitenden Faser (Faserspule) mit wenigstens einer Windung umgeben.

Vorteile magnetooptischer Meßanordnungen und Meßverfahren gegenüber herkömmlichen induktiven Stromwandlern sind die Potentialtrennung und die Unempfindlichkeit gegenüber elektromagnetischen Störungen. Probleme bereiten jedoch Temperatureinflüsse und insbesondere Einflüsse von mechanischen Biegungen und Vibrationen in der Sensoreinrichtung und den optischen Übertragungsstrecken, insbesondere Lichtleitfasern, zum Übertragen des Meßlichts.

In einer aus *WO 95/10045* bekannten Ausführungsform werden zwei linear polarisierte Lichtsignale in entgegengesetzten Richtungen durch eine Faraday-Sensoreinrichtung gesendet. Die Faraday-Sensoreinrichtung umgibt einen Stromleiter und weist eine im Vergleich zum Faraday-Effekt vernachlässigbare zirkuläre Doppelbrechung auf. Nach Durchlaufen der Sensoreinrichtung wird jedes der beiden Lichtsignale von einem polarisierenden Strahlteiler in zwei senkrecht zueinander linear polarisierte Lichtteilsignale zerlegt. Für jedes Lichtsignal wird nun ein intensitätsnormiertes Signal gebildet, das dem Quotienten aus einer Differenz und der Summe der beiden zugehörigen Lichtteilsignale entspricht. Aus den beiden intensitätsnormierten Signalen wird nun von einer Signalverarbeitung ein Meßsignal für einen elektrischen Strom in dem Stromleiter abgeleitet, das sowohl von der Temperatur als auch von Vibrationen in der Sensoreinrichtung praktisch unabhängig ist.

In drei weiteren bekannten Ausführungsformen durchlaufen zwei Lichtsignale eine optische Reihenschaltung aus einer ersten Lichtleitfaser, einem ersten Polarisator, einer Faraday-Sensoreinrichtung, einem zweiten Polarisator und einer zweiten Lichtleitfaser in zueinander entgegengesetztem Umlaufsinn. Beide Lichtsignale werden nach Durchlaufen der optischen Reihenschaltung von entsprechenden photoelektrischen Wandlern in jeweils ein elektrisches Intensitätssignal umgewandelt.

Bei der ersten, aus *US 4,916,387* bekannten Ausführungsform ist als Faraday-Sensoreinrichtung ein massiver Glasring vorgesehen, der den Stromleiter umgibt. Die Polarisationsachsen der beiden Polarisatoren sind um einen Winkel von 45° zueinander gedreht. Zur Kompensation von unerwünschten Intensitätsänderungen in den optischen Zuleitfasern wird bei diesem aus *US 4,916,387* bekannten Meßsystem davon ausgegangen, daß sich die unerwünschten Intensitätsänderungen (noise) und die Intensitätsänderungen aufgrund des Faraday-Effekts additiv überlagern mit unterschiedlichen Vorzeichen in den beiden elektrischen Intensitätssignalen und damit voneinander getrennt werden können.

Bei der zweiten, aus *Journal of Lightwave Technology, Vol.12. No. 10, October 1994, Seiten 1882 bis 1890* bekannten Ausführungsform ist eine Faserspule aus einer Single-Mode-Faser mit einer niedrigen Doppelbrechung als Faraday-Sensoreinrichtung vorgesehen. Die Polarisationsachsen der beiden Polarisatoren schließen einen von 0° verschiedenen Polarisatorwinkel miteinander ein, der vorzugsweise 45° beträgt. Licht einer Lichtquelle wird in zwei Lichtsignale aufgeteilt, und diese beiden Lichtsignale werden jeweils über einen optischen Koppler und eine zugeordnete Übertragungs-Lichtleitfaser an entgegengesetzten Enden in die Faraday-Faserspule eingekoppelt. Aus zwei elektrischen Intensitätssignalen I1 und I2, die den Lichtintensitäten der beiden Lichtsignale nach Durchlaufen der Reihenschaltung entsprechen, wird ein Meßsignal abgeleitet, das dem Quotienten (I1-I2)/(I1+I2) aus der Differenz und der Summe der beiden Intensitätssignale entspricht. Damit können die Dämpfungen der beiden Lichtleitfasern im wesentlichen kompensiert werden. Die Lichtintensitäten der beiden Lichtsignale beim Einkoppeln in die Reihenschaltung müssen allerdings genau gleich eingestellt werden.

Bei der dritten, aus *H.Sohlström et al, "Transmission loss compensation for Faraday effect fibre optic sensors", Conference Eurosensors VIII, Toulouse, 25.-28.9.1994* bekannten Ausführungsform einer magnetooptischen Meßanordnung ist eine optische Reihenschaltung aus einer ersten Multimode-Faser, einem ersten Polarisator, einer Faraday-Sensoreinrichtung, einem zweiten Polarisator und einer zweiten Multimode-Faser zwischen zwei Infrarot-Leuchtdioden geschaltet. Die beiden Leuchtdioden werden abwechselnd als Lichtquelle und als Photodetektor betrieben. Es durchläuft somit zu einem Zeitpunkt immer nur eines der beiden gegenläufigen Lichtsignale die Reihenschaltung. Die Umschalttaktfrequenz wird deshalb möglichst hoch gewählt.

Bei den drei zuletzt genannten, aus dem Stand der Technik bekannten Ausführungsformen wird ein von Intensitätsverlusten in dem gemeinsamen Lichtweg für die beiden gegenläufigen Lichtsignale unabhängiges Meßsignal (intensitätsnormiertes Meßsignal) abgeleitet. Dabei wird vorausgesetzt, daß diese Intensitätsverluste für beide Lichtsignale gleich groß sind und daß der gemeinsame Lichtweg somit reziprok ist.

Aus der Firmenschrift *"Optical Combined Current & Voltage H.V. Sensors, GEC Alsthom, T&D* ist ein magnetooptischer Stromwandler bekannt, bei dem ein in einem Polarisator linear polarisiertes Lichtsignal einen Faraday-Glasring durchläuft und danach von einem polarisierenden Strahlteiler in zwei senkrecht zueinander linear polarisierte Lichtteilsignale aufgespalten wird (zweikanalige Polarisationsauswertung). Beide Lichtteilsignale werden über jeweils eine Lichtleitfaser einer zugehörigen Photodiode zugeführt, die das entsprechende Lichtteilsignal in ein elektrisches Intensitätssignal S1 oder S2 umwandelt, das proportional zur Lichtintensität des zugehörigen Lichtteilsignals ist. Aufgrund unterschiedlicher Dämpfung in den beiden Lichtleitfasern können nun die beiden Proportionalitätskonstanten verschieden voneinander sein. Zum Ausgleich dieser Empfindlichkeitsunterschiede ist eine besondere Regelung vorgesehen. Ein der ersten Photodiode nachgeschalteter steuerbarer erster Verstärker verstärkt das Intensitätssignal S1 um einen zugehörigen Verstärkungsfaktor K1 und ein der zweiten Photodiode nachgeschalteter zweiter Verstärker das zweite Intensitätssignal S2 um einen zweiten Verstärkungsfaktor K2. Es werden nun Gleichsignalanteile (DC values) der beiden Intensitätssignale S1 und S2 bestimmt und die Differenz der beiden Gleichsignalanteile wird als Regelgröße auf Null geregelt durch Steuern des Verstärkungsfaktors K1 des ersten Verstärkers. Aus den beiden im allgemeinen unterschiedlich stark verstärkten Intensitätssignale K1·S1 und K2·S2 an den Ausgängen der beiden Verstärker wird nun ein Meßsignal gebildet, das dem Quotienten (K1·S1 - K2·S2)/( K1·S1 + K2·S2) aus der Differenz und der Summe der Ausgangssignale der Verstärker entspricht.

Der Erfindung liegt nun die Aufgabe zugrunde, ein Meßverfahren und eine Meßanordnung zum Messen eines magnetischen Wechselfeldes und insbesondere zum Messen eines elektrischen Wechselstromes unter Ausnutzung des Faraday-Effekts anzugeben, bei denen unerwünschte Intensitätsänderungen im Meßsignal weitgehend eliminiert sind.

Diese Aufgabe wird gemäß der Erfindung gelöst mit den Merkmalen des Anspruchs 1 bzw. des Anspruchs 6. Zwei Lichtsignale durchlaufen eine optische Reihenschaltung aus einer ersten optischen Übertragungsstrecke, einem ersten Polarisator, einer Faraday-Sensoreinrichtung, einem zweiten Polarisator und einer zweiten optischen Übertragungsstrecke in zueinander entgegengesetzten Durchlaufrichtungen. Aus den Lichtintensitäten der beiden Lichtsignale nach Durchlaufen der optischen Reihenschaltung und Gleichanteilen der beiden Lichtintensitäten wird ein intensitätsnormiertes Meßsignal für das magnetische Wechselfeld abgeleitet.

Die Erfindung beruht dabei auf der Erkenntnis, daß der von der optischen Reihenschaltung gebildete, von den beiden gegenläufigen Lichtsignalen gemeinsam durchlaufene Lichtweg nicht reziprok ist. Die von den beiden Lichtsignalen in der Reihenschaltung erfahrenen Intensitätsänderungen, insbesondere Dämpfungen, sind somit entgegen den im Stand der Technik gemachten Voraussetzungen nicht gleich. Ursachen für solche Nicht-Reziprokitäten im Lichtweg der beiden gegenläufigen Lichtsignale können Unstetigkeiten im Lichtweg sein, insbesondere an Stellen, an denen zwei optische Komponenten der optischen Reihenschaltung optisch miteinander gekoppelt werden. Beispiele für solche Unstetigkeiten sind gegeneinander verkippte Koppelflächen, allgemeine Fertigungsfehler und Streueffekte oder auch Versatz von Faserkernen von Lichtleitfasern zueinander. Besondere Probleme können optische Steckverbindungen in den beiden Übertragungsstrecken zum lösbaren optischen Verbinden zweier Lichtleitfasern bereiten. Solche Steckverbindungen sind zum Trennen der im allgemeinen auf unterschiedlichen elektrischen Potentialen liegenden Faraday-Sensoreinrichtung einerseits und der Auswerteelektronik andererseits von Vorteil. Bereits nach einmaligem Öffnen und darauffolgendem Schließen einer optischen Steckverbindung können sich die Dämpfungseigenschaften der Steckverbindung im Vergleich zu vorher ändern. Die genannten nicht-reziproken Intensitätsänderungen werden durch die Einbeziehung der Gleichsignalanteile der beiden Lichtintensitäten in die Intensitätsnormierung des Meßsignals praktisch vollständig beseitigt.

Vorteilhafte Ausgestaltungen und Weiterbildungen des Verfahrens und der Anordnung gemäß der Erfindung ergeben sich aus den jeweils abhängigen Ansprüchen.

In einer besonders vorteilhaften Ausführungsform wird ein Meßsignal abgeleitet, das proportional zum aus den beiden Lichtintensitäten I1 und I2 und deren beiden Gleichanteilen $I1_{DC}$ und $I2_{DC}$ gebildeten Signal

$$(I2_{DC} \cdot I1 - I1_{DC} \cdot I2) / (I2_{DC} \cdot I1 + I1_{DC} \cdot I2) \tag{1}$$

ist.

Das intensitätsnormierte Meßsignal kann in einer weiteren Ausführungsform auch mit Hilfe einer Regelung abgeleitet werden. Dazu wird ein Korrekturfaktor für eine der beiden Lichtintensitäten, insbesondere durch Stellen der Verstärkung eines steuerbaren Verstärkers für ein entsprechendes elektrisches Intensitätssignal, so lange angepaßt, bis die Differenz des Gleichanteils der mit dem Korrekturfaktor multiplizierten Lichtintensität und des Gleichanteils der anderen Lichtintensität innerhalb eines vorgegebenen Toleranzbereichs um Null liegt. Diese Differenz der Gleichanteile ist also die Regelgröße der Regelung. Durch die Regelung der Gleichanteildifferenz auf Null stimmen die beiden Gleichanteile bis auf eine vorgegebene Toleranz überein. Als Meßsignal wird ein zum Quotienten aus einer Differenz der mit dem Korrekturfaktor multiplizierten Lichtintensität und der anderen Lichtintensität und einer Summe der mit dem Korrekturfaktor multiplizierten Lichtintensität und der anderen Lichtintensität proportionales Signal gebildet.

In einer vorteilhaften Ausführungsform sind die Polarisationsachsen der beiden Polarisatoren um einen Winkel von wenigstens annähernd einem ungeradzahligen Vielfachen von 45° oder π/4 eingestellt. Damit wird der Arbeitspunkt des Meßverfahrens und der Meßanordnung so eingestellt, daß die Meßempfindlichkeit maximal ist.

Vorzugsweise werden das Meßverfahren und die Meßanordnung zum Messen eines elektrischen Wechselstromes verwendet, indem die Faraday-Sensoreinrichtung im magnetischen Wechselfeld des elektrischen Wechselstromes angeordnet wird und das Meßsignal als Maß für den elektrischen Wechselstrom herangezogen wird. Unter einem elektrischen Wechselstrom wird dabei und im folgenden ein elektrischer Strom verstanden, dessen Spektrum nur von Null verschiedene Frequenzanteile aufweist.

Zur weiteren Erläuterung der Erfindung wird auf die Zeichnung Bezug genommen, in deren

FIG 1    ein Ausführungsbeispiel einer Meßanordnung zum Messen eines magnetisches Wechselfeldes, insbesondere des magnetisches Wechselfeldes eines elektrischen Wechselstromes und

FIG 2    ein Ausführungsbeispiel einer Auswerteeinheit einer solchen Meßanordnung

jeweils schematisch dargestellt sind. Einander entsprechende Teile sind mit denselben Bezugszeichen versehen.

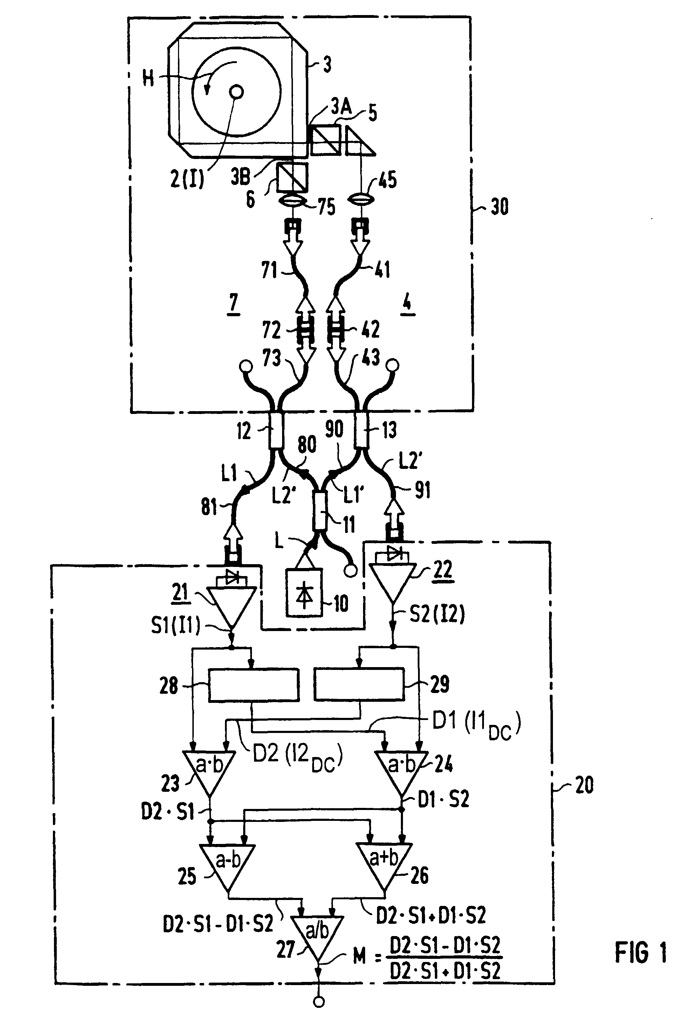

In der FIG 1 sind eine Lichtquelle mit 10, ein erster optischer Koppler mit 11, ein zweiter optischer Koppler mit 12, ein dritter optischer Koppler mit 13, eine Auswerteeinheit mit 20 und eine optische Reihenschaltung mit 30 bezeichnet. In der optischen Reihenschaltung 30 sind eine erste optische Übertragungsstrecke 4, ein erster Polarisator 5, eine Faraday-Sensoreinrichtung 3 und eine zweite optische Übertragungsstrecke 7 optisch in Reihe geschaltet. Der erste optische Koppler 11 ist mit der Lichtquelle 10 optisch verbunden und teilt Licht L der Lichtquelle 10 in zwei Lichtsignale L1' und L2' auf. Der zweite optische Koppler 12 koppelt das von der Sensoreinrichtung 3 angewandte Ende der zweiten Übertragungsstrecke 7 der Reihenschaltung 30 mit dem ersten optischen Koppler 11 einerseits und mit einem ersten photoelektrischen Wandler 21 in der Auswerteeinheit 20 andererseits. Der dritte optische Koppler 13 koppelt das von der Sensoreinrichtung 3 abgewandte Ende der ersten Übertragungsstrecke 4 der Reihenschaltung 30 mit dem ersten optischen Koppler 11 einerseits und mit einem zweiten photoelektrischen Wandler 22 in der Auswerteeinheit 20 andererseits. Die beiden Lichtsignale L1' und L2' werden somit vom ersten Koppler 11 an einander entgegengesetzten Enden über die optischen Koppler 12 bzw. 13 in die optische Reihenschaltung 30 eingekoppelt.

Beide Lichtsignale L1' und L2' durchlaufen die optische Reihenschaltung 30 nun in zueinander entgegengesetzten Durchlaufrichtungen. Nach Transmission durch die Reihenschaltung 30 werden die mit Ll bzw. L2 bezeichnete Lichtsignale wieder aus der Reihenschaltung 30 ausgekoppelt und über die jeweiligen optischen Koppler 13 bzw. 12 der Auswerteeinheit 20 zugeführt. Die Lichtintensitäten der beiden Lichtsignale L1' und L2' vor dem Einkoppeln in die Reihenschaltung 30 werden im allgemeinen in einem fest vorgegebenen Verhältnis zueinander eingestellt, das durch die Kopplungsverhältnisse der Koppler 11 bis 13 vorgebbar ist.

Die Lichtquelle 10 und die Koppler 11, 12 und 13 bilden eine Ausführungsform von Mitteln zum Senden der zwei gegenläufigen Lichtsignale L1' und L2' durch die Reihenschaltung 30. Die Koppler 11, 12 und 13 können auch wenigstens teilweise durch optische Strahlteiler ersetzt werden. Anstelle der Lichtquelle 10, der drei Koppler 11 bis 13 und der beiden Wandler 21 und 22 können auch abwechselnd als Sender und Detektor betriebene Leuchtdioden vorgesehen sein, die mit entsprechenden Stromquellen und Auswerteelektroniken elektrisch verbunden sind. Die beiden Lichtsignale L1' und L2' durchlaufen die Reihenschaltung 30 dann zeitlich hintereinander.

In der dargestellten vorteilhaften Ausführungsform sind die beiden optischen Übertragungsstrecken 4 und 7 faseroptisch ausgebildet und umfassen jeweils zwei Lichtleitfasern 41 und 43 bzw. 71 und 73, die über eine optische Steckverbindung 42 bzw. 72 trennbar miteinander verbunden sind. Eine solche Steckverbindung 42 bzw. 72 ist vorteilhaft, um die bei einer Strommessung im allgemeinen auf Hochspannung liegende Sensoreinrichtung 3 von der Auswerteeinheit 20 trennen zu können. Als Steckverbindung 42 bzw. 72 kann eine handelsübliche Fasersteckverbindung nach der FC-Norm (OECA) verwendet werden.

Die Koppler 12 und 13 sind nun Faserkoppler, die jeweils die zugehörige Lichtleitfaser 73 bzw. 43 der zweiten bzw. ersten Übertragungsstrecke 7 bzw. 4 mit jeweils zwei weiteren Lichtleitfasern 80 und 81 bzw. 90 und 91 koppeln. Auch der Koppler 11 ist nun ein Faserkoppler, der die beiden Lichtleitfasern 80 und 90 mit einer nicht bezeichneten weiteren Lichtleitfaser koppelt, die das Licht L der Lichtquelle 10 überträgt. Die Lichtleitfaser 80 überträgt das erste Lichtsignal L1' vor dem Einkoppeln in die Reihenschaltung 30. Die Lichtleitfaser 90 überträgt das zweite Lichtsignal L2' vor dem Einkoppeln in die Reihenschaltung 30. Die Lichtleitfaser 81 überträgt das erste Lichtsignal L1 nach Auskoppeln aus der Reihenschaltung 30. Die Lichtleitfaser 91 schließlich überträgt das zweite Lichtsignal L2 nach Auskoppeln aus der Reihenschaltung 30. Die Lichtleitfasern 41, 42, 71, 72, 80, 81, 90 und 91 können in ihrer Länge an Standortbedingungen angepaßt werden.

Die Faraday-Sensoreinrichtung 3 enthält wenigstens ein den magnetooptischen Faraday-Effekt zeigendes Material. Unter dem Einfluß eines die Sensoreinrichtung 3 wenigstens teilweise durchdringenden magnetischen Wechselfeldes **H** wird die Polarisation von durch die Sensoreinrichtung 3 laufendem linear polarisiertem Licht aufgrund des Faraday-Effekts gedreht. Die Sensoreinrichtung 3 kann in an sich bekannter Weise mit einem oder mehreren massiven Körpern, vorzugsweise aus Glas, und insbesondere wie dargestellt als massiver Glasring mit die Lichtsignale L1' und L2' umlenkenden inneren Reflexionsflächen oder auch mit mindestens einer optischen Faser ausgebildet sein. Die Sensoreinrichtung 3 weist zwei optische Anschlüsse 3A und 3B derart auf, daß an einem Anschluß 3A oder 3B eingekoppeltes Licht die Sensoreinrichtung 3 durchläuft und am jeweils anderen Anschluß 3B bzw. 3A wieder ausgekoppelt wird. Der erste Anschluß 3A der Sensoreinrichtung 3 ist über den ersten Polarisator 5 und vorzugsweise über eine Kollimatorlinse 45 mit einem Ende der ersten optischen Übertragungsstrecke 4 optisch gekoppelt. Der zweite Anschluß 3B der Sensoreinrichtung 3 ist über den zweiten Polarisator 6 und vorzugsweise über eine weitere Kollimatorlinse 75 mit einem Ende der zweiten optischen Übertragungsstrecke 7 optisch gekoppelt.

Im Meßbetrieb der Anordnung durchläuft nun das erste Lichtsignal L1' die erste Übertragungsstrecke 4 und wird von dem ersten Polarisator 5 linear polarisiert. Das nunmehr linear polarisierte Lichtsignal L1' wird anschließend am Anschluß 3A in die Sensoreinrichtung 3 eingespeist. Beim Durchlaufen der Sensoreinrichtung 3 wird die Polarisationsebene des linear polarisierten ersten Lichtsignals L1' um einen vom magnetischen Wechselfeld **H** abhängigen Faraday-Meßwinkel $\rho$ gedreht. Ein positiver Winkelwert entspricht dabei und im folgenden dem mathematisch positiven Drehsinn, also dem Gegenuhrzeigersinn, ein negativer Winkelwert dagegen dem mathematisch negativen Drehsinn, d.h. dem Uhrzeigersinn, bezogen auf die Ausbreitungsrichtung des betrachteten Lichtsignals. Das in seiner Polarisationsebene um den Faraday-Meßwinkel $\rho$ gedrehte erste Lichtsignal L1' wird nun dem zweiten Polarisator 6 zugeführt. Der zweite Polarisator 6 läßt nur den auf seine Polarisationsachse projizierten Anteil des ankommenden ersten Lichtsignals L1' durch und hat somit für das erste Lichtsignal L1' die Funktion eines Polarisationsanalysators. Der vom zweiten Polarisator 6 transmittierte Anteil des ersten Lichtsignals L1' wird über die zweite Übertragungsstrecke 7 und den zweiten Koppler 12 als erstes Lichtsignal L1 dem ersten Wandler 21 zugeführt. Das zweite Lichtsignal L2' wird über die zweite Übertragungsstrecke 7 dem zweiten Polarisator 5 zugeführt und von diesem linear polarisiert. Beim anschließenden Durchlaufen der Sensoreinrichtung 3 wird die Polarisationsebene des linear polarisierten zweiten Lichtsignals L2' um einen vom magnetischen Wechselfeld **H** abhängigen Faraday-Meßwinkel $-\rho$ gedreht, der wegen der nicht-reziproken Eigenschaft des Faraday-Effekts den gleichen Betrag, aber das entgegengesetzte Vorzeichen aufweist wie beim ersten Lichtsignal L1'. Der erste Polarisator 5 läßt nur den auf seine Polarisationsachse projizierten Anteil des ankommenden zweiten Lichtsignals L2' durch und wirkt somit für das zweite Lichtsignal L2' als Polarisationsanalysator. Der vom ersten Polarisator 5 transmittierte Anteil des zweiten Lichtsignals L2' wird über die erste Übertragungsstrecke 4 als mit L2 bezeichnetes zweites Lichtsignal zum zweiten Wandler 22 der Auswerteeinheit 20 übertragen.

Die Polarisationsachsen (polarization axis, transmission axis) der beiden Polarisatoren 5 und 6 sind in allen Ausführungsformen vorzugsweise unter einem Polarisatorwinkel $\alpha$ von einem ungeradzahliges Vielfaches von etwa 45° oder etwa $\pi/4$ eingestellt. Bei einer solchen Einstellung liegt der Arbeitspunkt der Messung bei maximaler Meßempfindlichkeit.

Die dargestellte Meßanordnung ist vorzugsweise zum Messen eines elektrischen Wechselstromes I in wenigstens einem Stromleiter 2 vorgesehen. Die Faraday-Sensoreinrichtung 3 erfaßt das von diesem Wechselstrom I induktiv erzeugte magnetische Wechselfeld **H** und dreht die Polarisationsebenen der beiden Lichtsignale L1' und L2' um einen vom magnetischen Wechselfeld **H** und damit vom Wechselstrom I abhängigen Meßwinkel $\rho$ bzw. $-\rho$. In der dargestellten, besonders vorteilhaften Ausführungsform umgibt die Sensoreinrichtung 3, insbesondere als Glasring, den Stromleiter 2, so daß beide Lichtsignale L1' und L2' den Wechselstrom I in einem praktisch geschlossenen Lichtpfad umlaufen. Der Meßwinkel $\rho$ ist in diesem Fall direkt proportional zum elektrischen Wechselstrom I.

Die Auswertung der beiden Lichtsignale L1 und L2 in der Auswerteeinheit 30 geschieht vorzugsweise folgendermaßen. Der erste photoelektrische Wandler 21 wandelt das erste Lichtsignal L1 in ein erstes elektrisches Intensitätssignal S1 um, das im wesentlichen proportional zur Lichtintensität I1 des ersten Lichtsignals L1 ist, also $S1 = K1 \cdot I1$. Der zweite photoelektrische Wandler 22 wandelt das zweite Lichtsignal L2 in ein zweites elektrisches Intensitätssignal S2 um, das im wesentlichen proportional zur Lichtintensität I2 des zweiten Lichtsignals L2 ist, also S2 = K2·I2. Die Proportionalitätsfaktoren K1 und K2 dieser Umwandlungen sind von den photoelektrischen Wirkungsgraden und den anschließenden Verstärkungen der Signale in den Wandlern 21 und 22 bestimmt und können sich insbesondere auch mit der Zeit ändern. Jedes der beiden Intensitätssignale S1 und S2 wird einem Eingang eines zugehörigen ersten Multiplizieres 23 bzw. zweiten Multiplizierers 24 und einem Eingang eines zugehörigen ersten Filters 28 bzw. zweiten Filters 29 mit Tiefpaßcharakter zugeführt. Das erste Filter 28 bildet einen Gleichsignalanteil D1 des ersten Intensitätssignals S1, der dem Kl-fachen Gleichanteil $I1_{DC}$ der Lichtintensität I1 des ersten Lichtsignals L1 entspricht, also D1 = $K1·I1_{DC}$. Der an einem Ausgang des Filters 28 anstehende Gleichsignalanteil D1 des ersten Intensitätssignals S1 wird einem zweiten Eingang des ersten Multiplizierers 23 zugeführt. Das zweite Filter 29 bildet einen Gleichsignalanteil D2 des zweiten Intensitätssignals S2, der dem K2-fachen Gleichanteil $I2_{DC}$ der Lichtintensität I2 des zweiten Lichtsignals L2 entspricht, also D2 = $K2·I2_{DC}$. Der an einem Ausgang des zweiten Filters 29 anstehende Gleichsignalanteil D2 des zweiten Intensitätssignals S2 wird einem zweiten Eingang des zweiten Multiplizierers 24 zugeführt. Als Filter 28 und 29 können beispielsweise Tiefpaßfilter eingesetzt werden, deren Trennfrequenzen jeweils unterhalb der niedrigsten Frequenz im Spektrum des magnetischen Wechselfeldes **H** bzw. des elektrischen Wechselstromes I eingestellt sind.

Die beiden Gleichsignalanteile D1 und D2 und somit auch die beiden Gleichlichtanteile $I1_{DC}$ und $I2_{DC}$ enthalten somit keine Informationen über das magnetische Wechselfeld **H** bzw. den elektrischen Wechselstrom I, jedoch gerade die Informationen über eine unerwünschte Gleichdrift (Arbeitspunktdrift) der beiden Lichtintensitäten I1 und I2. Diese Informationen über eine Intensitätsdrift werden nun wie folgt für eine Intensitätsnormierung verwendet. Der erste Multiplizierer 23 bildet das Produkt D2·S1 des ersten Intensitätssignals S1 und des Gleichsignalanteils D2 des zweiten Intensitätssignals S2. Der zweite Multiplizierer 24 bildet das Produkt D1·S2 des Gleichsignalanteils D1 des ersten Intensitätssignals S1 und des zweiten Intensitätssignals S2. Diese beiden Produkte D2·S1 und D1·S2 werden nun von dem Ausgang des entsprechenden Multiplizierers 23 bzw. 24 jeweils einem Eingang eines Subtrahierers 25 und jeweils einem Eingang eines Addierers 26 zugeführt. Das vom Subtrahierer 25 gebildete Differenzsignal D2·S1-D1·S2 der beiden Produktsignale D2·S1 und D1·S2 wird an einen ersten Eingang eines Dividierers 27 angelegt. Am zweiten Eingang des Dividierers 27 liegt das vom Addierer 26 gebildete Summensignal D2·S1+D1·S2 der beiden Produkte D2·S1 und D1·S2 an. An einem Ausgang des Dividierers 27 kann nun das Meßsignal

$$M = (D2·S1 - D1·S2)/(D2·S1 + D1·S2) \tag{2}$$

für das magnetische Wechselfeld **H** bzw. für den elektrischen Strom I abgegriffen werden, das dem Quotientensignal aus der Differenz D2·S1-D1·S2 und der Summe D2·I1+D1·I2 entspricht.

In einer nicht dargestellten, abgewandelten Ausführungsform der Signalauswertung in der Auswerteeinheit 20 wird zunächst ein Quotient der beiden Gleichsignalanteile D1 und D2 als Korrekturfaktor K = D1/D2 ermittelt. Mit diesem Korrekturfaktor K wird ein Meßsignal

$$M' = (S1 - K · S2)/(S1 + K · S2) \tag{3}$$

gebildet.

Die beiden Meßsignale M gemäß Gleichung (2) und M' gemäß Gleichung (3) sind beide gleich dem gemäß Gleichung (1) direkt aus den Lichtintensitäten I1 und I2 und deren Gleichanteilen $I1_{DC}$ und $I2_{DC}$ gebildeten Quotienten. Es gilt demnach:

$$M = M' = (I1 · I2_{DC} - I2 · I1_{DC})/(I1 · I2_{DC} + I2 · I1_{DC}) \tag{4}$$

Die Empfindlichkeiten K1 und K2 der beiden Wandler 21 und 22 fallen bei der Bildung des Meßsignals M gemäß Gleichung (2) oder des Meßsignals M' gemäß Gleichung (3) somit heraus.

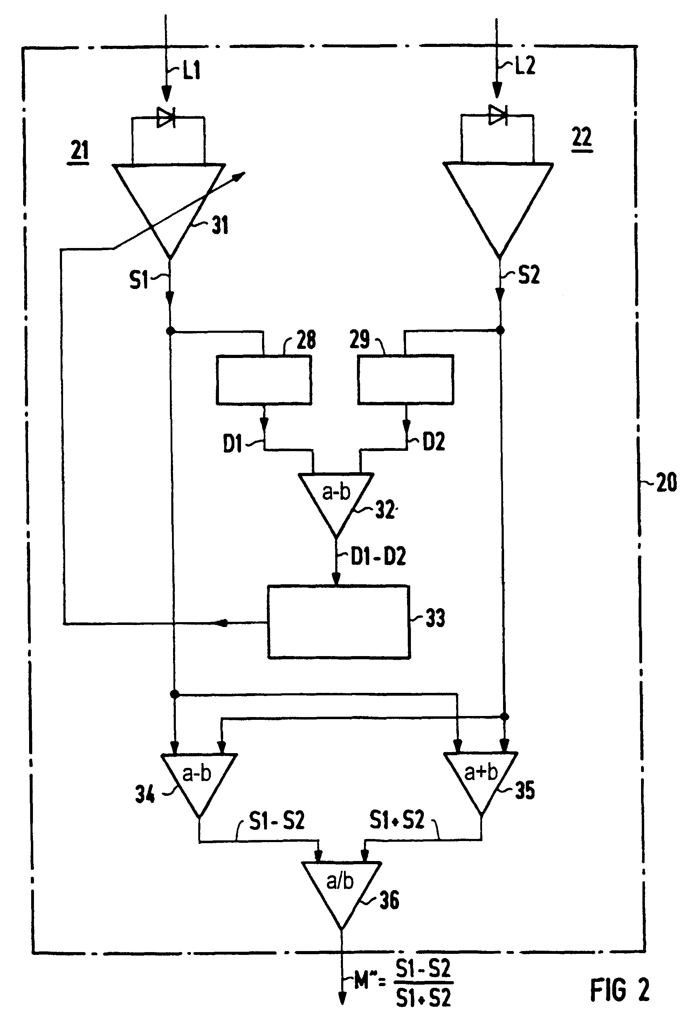

FIG 2 zeigt eine weitere Ausführungsform der Auswerteeinheit 20 zum Ableiten eines intensitätsnormierten Meßsignals M'' aus den Intensitätssignalen S1 = K1 · I1 und S2 = K2 · I2 und deren Gleichsignalanteilen D1 = K1 · $I1_{DC}$ bzw. D2 = K2 · $I2_{DC}$. Die Auswerteeinheit 20 enthält einen Regelkreis mit einem Regler 33 und einem steuerbarer Verstärker 31 als Stellglied, der von dem Regler 33 angesteuert wird. Der steuerbare Verstärker 31 ist entweder Bestandteil eines der beiden photoelektrischen Wandler oder einem der beiden photoelektrischen Wandler nachgeschaltet. Im dargestellten Ausführungsbeispiel ist der steuerbare Verstärker 31 Teil des ersten photoelektrischen Wandlers 21 und ist einer Photodiode als Photodetektor nachgeschaltet zum Verstärken des Signals der Photodiode. Die Amplitude des ersten Intensitätssignals S1 am Ausgang des Wandlers 21 ist somit durch Steuern des Verstärkungsfaktors des steuerbaren Verstärkers 31 steuerbar. Dies entspricht einer Steuerung des Proportionalitätsfaktors (Korrekturfaktors) K1, über den das Intensitätssignal S1 proportional zur Lichtintensität I1 ist. Auch der zweite Wandler 22 enthält vorzugsweise eine Photodiode und einen nachgeschalteten Verstärker mit fest eingestellter Verstärkung. Der Proportionalitätsfaktor K2 des zweiten Intensitätssignals S2 wird somit nicht verändert. Die Auswerteeinheit enthält ferner wieder die beiden Filter 28 und 29 zum Bilden der Gleichsignalanteile D1 und D2 der beiden Intensitätssignale S1 und S2, die an den Ausgängen der Wandler 21 bzw. 22 anstehen, sowie einen mit den Ausgängen der beiden Filter 28 und 29 verbundenen Subtrahierer 32 zum Bilden der Differenz D1-D2 der beiden Gleichsignalanteile D1 und D2. Diese Differenz D1-D2 wird als Regelgröße dem Regler 33 zugeführt. Der Regler 33 vergleicht die Regelgröße D1-D2 mit einem Nullsignal als Sollwert und steuert die Verstärkung des steuerbaren Verstärkers 31 solange, bis die Regelabweichung zwischen der Regelgröße D1-D2 und dem Sollwert 0 innerhalb eines vorgegebenen Toleranzbereichs liegt. Im eingeregelten Zustand sind somit die beiden Gleichsignalanteile D1 und D2 gleich, das heißt

$$K1 \cdot I1_{DC} = K2 \cdot I2_{DC} \tag{5}.$$

Aus dem über diese Regelung eingestellten ersten Intensitätssignal S1 und dem von der Regelung nicht veränderten zweiten Intensitätssignal S2 wird nun ein Meßsignal

$$M'' = (S1 - S2) / (S1 + S2) =$$

$$= (K1 \cdot I1 - K2 \cdot I2)/(K1 \cdot I1 + K2 \cdot I2) \tag{6}$$

gebildet, das dem Quotienten aus der Differenz S1-S2 und der Summe S1+S2 der beiden Intensitätssignale SI und S2 an den Ausgängen der Wandler 21 und 22 entspricht. Für die Bildung dieses Meßsignals M'' sind ein Subtrahierer 34 zum Bilden der Differenz S1-S2, ein Addierer 35 zum Bilden der Summe S1+S2 und ein Dividierer 36 zum Bilden des Quotientensignals aus der Differen S1-S2 und der Summe S1+S2 als Meßsignal M'' in der Auswerteeinheit 20 vorgesehen.

Anstelle mit analogen arithmetischen Bausteinen, wie dargestellt, kann die Auswerteeinheit 20 das Meßsignal M gemäß Gleichung (2) oder das Meßsignal M' gemäß Gleichung (3) oder das Meßsignal M'' gemäß Gleichung (6) auch mit Hilfe einer Wertetabelle und/oder mit Hilfe von digitalen Bausteinen ermitteln. Die beiden elektrischen Intensitätssignale S1 und S2 werden dann zunächst mit Hilfe eines. Analog/Digital-Wandlers digitalisiert und die digitalisierten Signale werden von einem Mikroprozessor oder einem digitalen Signalprozessor für das Meßsignal M oder M' oder M'' weiterverarbeitet.

Das gemäß einer der Gleichungen (2) bis (4) oder Gleichung (6) ermittelte Meßsignal M bzw. M' bzw. M'' ist praktisch vollständig intensitätsnormiert. Das bedeutet, daß sich unerwünschte Änderungen der Lichtintensitäten I1 und I2 der beiden Lichtsignale L1 und L2 aufgrund von Übertragungsverlusten durch Dämpfung, Reflexionen oder Streuung in der Reihenschaltung 30 oder aufgrund von Vibrationen oder mechanischen Biegungen insbesondere in den beiden Übertragungsstrecken 4 und 7, nicht mehr auf das Meßsignal M oder M' oder M'' auswirken. Besonders an den Anschlüssen 3A und 3B der Sensoreinrichtung 3 sowie an den Steckverbindungen 42 und 72 können Streueffekte und Reflexionen auftreten. Die vollständige Intensitätsnormierung des Meßsignals M oder M' oder M'' kann man erkennen, wenn man die Intensitätsänderungen in der Reihenschaltung 30 durch zusätzliche Übertragungsfaktoren C1 und C2 in den Lichtintensitäten I1 und I2 berücksichtigt. Unter dem im allgemeinen zeitabhängigen (reellen) Übertragungsfaktor einer optischen Übertragungsstrecke versteht man das Verhältnis der Lichtintensität von an einem Ende der Übertragungsstrecke ankommendem Licht zu der Eingangslichtintensität des Lichts beim Einkoppeln in das andere Ende der Übertragungsstrecke. Für die Lichtintensitäten I1 und I2 der beiden Lichtsignale LI und L2 nach Durchlaufen der optischen Reihenschaltung 30 gilt dann:

$$I1 = B1 \cdot C1 \cdot I0 \cdot \cos^2(\rho+\alpha) \tag{7}$$

$$I2 = B2 \cdot C2 \cdot I0 \cdot \cos^2(\rho-\alpha) \tag{8}.$$

I0 ist die Lichtintensität des Lichts L der Lichtquelle 10. B1 und B2 sind Kopplungsfaktoren, der sich aus den Kopplungsverhältnissen der Koppler 11, 12 und 13 ergeben. Wenn die Kopplungsverhältnisse aller Koppler 11, 12 und 13 jeweils 50%:50% sind, ist B1 = B2. Die $\cos^2$-Terme in den Gleichungen (7) und (8) beschreiben die Abhängigkeit der Lichtintensität I1 bzw. I2 von dem Faraday-Meßwinkel $\rho$ für einen vorgegebenen Polarisatorwinkel $\alpha$. Lineare Doppelbrechungseffekte in der Sensoreinrichtung 3 sind dabei vernachlässigt. Für die Gleichanteile $I1_{DC}$ und $I2_{DC}$ der beiden Lichtintensitäten I1 und I2 folgt aus den beiden Gleichungen (7) und (8):

$$I1_{DC} = B1 \cdot C1 \cdot I0 \cdot (\cos^2(\rho+\alpha))_{DC} \qquad (9)$$

$$I2_{DC} = B2 \cdot C2 \cdot I0 \cdot (\cos^2(\rho-\alpha))_{DC} \qquad (10)$$

Einsetzen der Gleichungen (7) bis (10) in die Gleichung (4) oder in die Gleichung (6) unter Berücksichtigung der Gleichung (5) liefert als Meßsignal

$$M = M' = M'' = \sin(2\alpha) \cdot \sin(2\rho) \qquad (11)$$

da $(\cos^2(\rho-\alpha))_{DC} = (\cos^2(\rho+\alpha))_{DC}$. Für den bevorzugten Polarisatorwinkel $\alpha = \pm 45°$ ist M = M' = M'' = sin(2$\rho$). Die die Intensität beeinflussenden Faktoren B1, B2, C1, C2 und I0 fallen beim Einsetzen heraus.

Somit können in allen Ausführungsformen auch einfache, vergleichsweise preiswerte Telekommunikationslichtfasern (Multimode-Fasern) als Lichtleitfasern 41, 43, 71 und 73 verwendet werden, da deren relativ hohe Dämpfungen und Vibrationsempfindlichkeiten im Meßsignal kompensiert sind. Als Übertragungsstrecken 4 und 7 können aber auch andere Lichtwellenleiter oder Freistrahlanordnungen verwendet werden.

Aus dem Meßsignal M oder M' oder M'' kann dann der elektrische Wechselstrom I im Stromleiter 2 mit Hilfe der Beziehung $\rho$ = N V I mit der Verdet-Konstanten V des Faraday-Effekts in der Sensoreinrichtung 3 und der Zahl N der Umläufe der Lichtsignale L1' und L2' um den Stromleiter 2 ermittelt werden.

Ein zusätzliches Problem bei der Messung eines magnetischen Wechselfeldes **H** oder eines elektrischen Wechselstromes I gemäß einem der beschriebenen Meßverfahren oder einer der beschriebenen Meßanordnungen können Temperatureinflüsse in der Sensoreinrichtung 3 darstellen. Diese Temperatureinflüsse induzieren eine lineare Doppelbrechung $\delta$ als Funktion $\delta$(T) der Temperatur T in der Sensoreinrichtung 3, die die Messung des magnetischen Wechselfeldes **H** oder des elektrischen Wechselstromes I verfälschen kann. Ferner können Temperaturänderungen auch die Verdet-Konstante und damit die Meßempfindlichkeit verändern.

Diese Temperaturabhängigkeit des Meßsignals M, M' oder M'' wird nun durch die im folgenden beschriebenen Maßnahmen zur Temperaturkompensation im wesentlichen beseitigt. Die Polarisationsachsen der beiden Polarisatoren 5 und 6 werden unter einem nicht dargestellten Polarisatorwinkel $\gamma$ zu einer Eigenachse (Hauptachse, optische Achse) der linearen Doppelbrechung $\delta$ in der Sensoreinrichtung 3 eingestellt. Der Polarisatorwinkel $\gamma$ ist wenigstens annähernd gemäß der Gleichung

$$\cos(4\gamma - 2\alpha) = -2/3 \qquad (12)$$

bestimmt. Eine Eigenachse der linearen Doppelbrechung $\delta$ ist dabei durch diejenige Polarisationsrichtung definiert, unter der in die Sensoreinrichtung 3 eingekoppeltes linear polarisiertes Licht die Sensoreinrichtung 3 unverändert wieder verläßt. Wird linear polarisiertes Licht dagegen mit einer nicht parallel zu einer der Eigenachsen der Sensoreinrichtung 3 gerichteten Polarisationsebene in die Sensoreinrichtung 3 eingekoppelt, so wird das Licht beim Durchlaufen der Sensoreinrichtung 3 aufgrund der linearen Doppelbrechung $\delta$ elliptisch polarisiert. Die im allgemeinen zueinander orthogonalen beiden Eigenachsen der linearen Doppelbrechung $\delta$ können in an sich bekannter Weise bestimmt werden. Beispielsweise kann die Sensoreinrichtung 3 zwischen einem Polarisator, beispielsweise dem Polarisator 5, und einem Analysator, beispielsweise dem Polarisator 6, angeordnet werden. Die Polarisationsachsen der beiden Polarisatoren werden senkrecht zueinander eingestellt. Nun werden in einer Ausführungsform die beiden Polarisationsachsen von Polarisator und Analysator gleichsinnig gegen eine Bezugsachse der Sensoreinrichtung 3 gedreht, bis die Intensität des vom Analysator transmittierten Lichts gleich Null ist (maximale Lichtauslöschung). Die Eigenachsen sind dann parallel zu den beiden Polarisationsachsen von Polarisator und Analysator. Alternativ dazu können in einer anderen Ausführungsform die beiden Polarisationsachsen auch gleichsinnig gegen die Bezugsachse der Sensoreinrichtung 3 gedreht werden, bis die Intensität des vom Analysator transmittierten Lichts maximal ist (minimale Lichtauslöschung). In diesem Fall ist das Licht beim Austreten aus der Sensoreinrichtung 3 zirkular polarisiert. Die Eigenachsen der linearen Doppelbrechung $\delta$ liegen dann um 45° bzw. -45° versetzt zur Polarisationsachse des Analysators.

Wählt man den bevorzugten Drehwinkel $\alpha$ = - 45° oder $\alpha$ = - 45° - n · 180° = - (1+4n) · 45° mit der beliebigen ganzen Zahl n, so reduziert sich die Gleichung (11) auf

$$\sin (4\gamma) = + 2/3 \qquad (12).$$

Ein möglicher, die Gleichung (12) erfüllender Wert für den Polarisatorwinkel $\gamma$ ist beispielsweise $\gamma$ = + 10,45°. Bei dem Drehwinkel $\alpha$ = + 45° oder $\alpha$ = + (1+4n) · 45° mit der beliebigen ganzen Zahl n reduziert sich die Gleichung (11) dagegen auf

$$\sin (4\gamma) = - 2/3 \qquad (13).$$

Ein Polarisatorwinkel $\gamma$, der Gleichung (13) erfüllt, ist beispielsweise $\gamma$ = - 10,45°.

Abweichungen von den die Gleichung (11), (12) oder (13) exakt erfüllenden Winkelwerten für den Polarisatorwinkel $\gamma$ sind möglich, insbesondere bei inhomogener linearer und/oder zirkularer Doppelbrechung und/oder einer stark temperaturabhängigen Verdet-Konstanten in der Sensoreinrichtung 3, und können im allgemeinen bis zu etwa 5° betragen. Auch der Drehwinkel $\alpha$ kann bis zu etwa $\pm$ 10° von seinem Idealwert $\alpha$ = + (1+4n) · 45° oder $\alpha$ = - (1+4n) · 45° für die Temperaturkompensation abweichen.

Das mit einem wenigstens annähernd gemäß Gleichung (11), (12) oder (13) eingestellten Polarisatorwinkel $\gamma$ ermittelte Meßsignal entspricht nun auch bei sich ändernden Temperaturen in der Sensoreinrichtung 3 im wesentlichen dem zu $\sin(2\rho)$ proportionalen Meßsignal ohne lineare Doppelbrechung $\delta$. Der gemäß Gleichung (11), (12) oder (13) optimale Polarisatorwinkel $\gamma$ der beiden Polarisatoren 5 bzw. 6 zur Eigenachse der linearen Doppelbrechung $\delta$ kann in einer besonderen Ausführungsform einfach so eingestellt werden, daß man in einer Eichmessung das Meßsignal in seiner Abhängigkeit von der Temperatur mit seinem zu erwartenden Sollwert ohne lineare Doppelbrechung $\delta$ für einen vorgegebenen Polarisatorwinkel $\gamma$ als Parameter vergleicht und den Polarisatorwinkel $\gamma$ so lange verändert, bis das aktuelle Meßsignal M, M' oder M'' mit dem praktisch temperaturunabhängigen Sollwert übereinstimmt. Die Bandbreite der Messung wird durch die vorbeschriebene Temperaturkompensation nicht reduziert.

**Patentansprüche**

1. Verfahren zum Messen eines magnetischen Wechselfeldes (H), bei dem

    a) zwei Lichtsignale (L1,L2) eine optische Reihenschaltung (30) aus einer ersten optischen Übertragungsstrecke (4), einem ersten Polarisator (5), einer den Faraday-Effekt zeigenden Sensoreinrichtung (3), einem zweiten Polarisator (6) und einer zweiten optischen Übertragungsstrecke (7) in zueinander entgegengesetzten Richtungen durchlaufen,

    b) die Lichtintensitäten (I1,I2) der beiden Lichtsignale (L1,L2) nach deren Durchlaufen der optischen Reihenschaltung (30) in zu diesen Lichtintensitäten (I1,I2) proportionale elektrische Intensitätssignale (S1,S2) umgewandelt werden,

    c) aus den beiden elektrischen Intensitätssignalen (S1,S2) jeweils ein Gleichsignalanteil (D1,D2) gebildet wird, der proportional zu einem Gleichlichtanteil ($I1_{DC}$,$I2_{DC}$) der Lichtintensität (I1,I2) des jeweiligen Lichtsignals (L1, L2) ist, wobei die Gleichlichtanteile ($I1_{DC}$,$I2_{DC}$) keine Frequenzanteile des magnetischen Wechselfeldes (**H**) enthalten, und

    d) aus den elektrischen Intensitätssignalen (S1,S2) und deren Gleichsignalanteilen (D1,D2) ein von Intensitätsänderungen in der optischen Reihenschaltung (30) praktisch unabhängiges Meßsignal (M,M'') für das magnetische Wechselfeld (**H**) gebildet wird.

2. Verfahren nach Anspruch 1, bei dem das Meßsignal (M) proportional zum Quotienten

$$(I2_{DC} \cdot I1 - I1_{DC} \cdot I2) / (I2_{DC} \cdot I1 + I1_{DC} \cdot I2)$$

ist, wobei I1 die Lichtintensität eines ersten der beiden Lichtsignale (L1) und $I1_{DC}$ deren Gleichanteil sowie I2 die Lichtintensität eines zweiten der beiden Lichtsignale (L2) und $I2_{DC}$ deren Gleichanteil sind.

3. Verfahren nach Anspruch 1, bei dem

a) der Gleichanteil ($I1_{DC}$) der Lichtintensität (I1) eines ersten der beiden Lichtsignale (L1) mit einem Korrekturfaktor multipliziert wird und dieser Korrekturfaktor so lange angepaßt wird, bis die Differenz zwischen dem mit dem Korrekturfaktor multiplizierten Gleichanteil ($I1_{DC}$) und dem Gleichanteil ($I2_{DC}$) der Lichtintensität (I2) des zweiten Lichtsignals (L2) innerhalb eines vorgegebenen Toleranzbereichs um Null liegt,

b) ein zum Quotienten aus einer Differenz der mit dem genannten Korrekturfaktor multiplizierten Lichtintensität (I1) des ersten Lichtsignals (L1) und der Lichtintensität (I2) des zweiten Lichtsignals (L2) und aus der Summe der mit dem genannten Korrekturfaktor multiplizierten Lichtintensität (I1) des ersten Lichtsignals (L1) und der Lichtintensität (I2) des zweiten Lichtsignals (L2) proportionales Meßsignal (M") gebildet wird.

4. Verfahren nach einem der Ansprüche 1 bis 3, bei dem die Polarisationsachsen der beiden Polarisatoren (5,6) um einen Winkel ($\alpha$) von wenigstens annähernd ± 45° gegeneinander gedreht werden.

5. Verfahren nach einem der vorhergehenden Ansprüche, bei dem das magnetische Wechselfeld (**H**) eines elektrischen Wechselstromes (I) gemessen wird und das Meßsignal (M,M") als Maß für den elektrischen Wechselstrom (I) herangezogen wird.

6. Anordnung zum Messen eines magnetischen Wechselfeldes (**H**) mit

a) einer optischen Reihenschaltung (30) aus einer ersten optischen Übertragungsstrecke (4), einem ersten Polarisator (5), einer den Faraday-Effekt zeigenden Sensoreinrichtung (3), einem zweiten Polarisator (6) und einer zweiten optischen Übertragungsstrecke (7),

b) Mitteln (10,11,12,13) zum Senden von zwei Lichtsignalen (L1,L2) durch die optische Reihenschaltung (30) in zueinander entgegengesetzten Richtungen,

c) Mitteln (21,22) zum Umwandeln von Lichtintensitäten (I1, I2) der beiden Lichtsignale (L1,L2) nach deren Durchlaufen der optischen Reihenschaltung (30) in zu diesen Lichtintensitäten (I1,I2) proportionale elektrische Intensitätssignale (S1,S2),

d) Mitteln (28,29) zum Bilden jeweils eines Gleichsignalanteils (D1,D2) aus den beiden elektrischen Intensitätssignalen (S1,S2), wobei der jeweilige Gleichsignalanteil (D1,D2) proportional zu einem Gleichlichtanteil ($I1_{DC}$, $I2_{DC}$) der Lichtintensität (I1,I2) des jeweiligen Lichtsignals (L1,L2) ist, und wobei die Gleichlichtanteile ($I1_{DC}$,$I2_{DC}$) keine Frequenzanteile des magnetischen Wechselfeldes (**H**) enthalten, und

e) Mitteln (23,24,25,26,27,31,32,33,34,35,36) zum Bilden eines von Intensitätsänderungen in der optischen Reihenschaltung (30) praktisch unabhängigen Meßsignals (M,M") für das magnetische Wechselfeld (**H**) aus den elektrischen Intensitätssignalen (S1,S2) und deren Gleichsignalanteilen (D1,D2).

7. Anordnung nach Anspruch 6, bei der das Meßsignal (M) proportional zum Quotienten

$$(I2_{DC} \cdot I1 - I1_{DC} \cdot I2) / (I2_{DC} \cdot I1 + I1_{DC} \cdot I2)$$

ist, wobei I1 die Lichtintensität eines ersten der beiden Lichtsignale (L1) und $I1_{DC}$ deren Gleichanteil sind sowie I2 die Lichtintensität eines zweiten der beiden Lichtsignale (L2) und $I2_{DC}$ deren Gleichanteil sind.

8. Anordnung nach Anspruch 6, bei der in der Auswerteeinheit (20)

a) ein Regler (33) vorgesehen ist zum Regeln der Differenz zwischen dem mit einem Korrekturfaktor multiplizierten Gleichanteil ($I1_{DC}$) der Lichtintensität (I1) eines ersten der beiden Lichtsignale (L1) und dem Gleichanteil ($I2_{DC}$) der Lichtintensität (I2) des zweiten Lichtsignals (L2) auf den Sollwert Null durch Stellen des Korrekturfaktors und ferner

b) Mittel (34,35,36) vorgesehen sind zum Bilden eines zum Quotienten aus einer Differenz der mit dem genannten Korrekturfaktor multiplizierten Lichtintensität (I1) des ersten Lichtsignals (L1) und der Lichtintensität (I2) des zweiten Lichtsignals (L2) und aus der Summe der mit dem genannten Korrekturfaktor multiplizierten Lichtintensität (I1) des ersten Lichtsignals (L1) und der Lichtintensität (I2) des zweiten Lichtsignals (L2) proportionalen Meßsignals (M").

9. Anordnung nach einem der Ansprüche 6 bis 8, bei der die Polarisationsachsen der beiden Polarisatoren (5,6) um einen Winkel ($\alpha$) von wenigstens annähernd ± 45° gegeneinander gedreht sind.

10. Anordnung nach einem der Ansprüche 6 bis 9, bei der die Sensoreinrichtung (3) im magnetischen Wechselfeld (**H**) eines elektrischen Wechselstromes (I) angeordnet ist und die Auswertemittel (20) das Meßsignal (M) als Maß für den elektrischen Wechselstrom (I) ableiten.

11. Anordnung nach einem der Ansprüche 6 bis 10, bei der die beiden optischen Übertragungsstrecken (4,7) der Reihenschaltung (30) Lichtleitfasern umfassen.

12. Anordnung nach Anspruch 11, bei der die beiden optischen Übertragungsstrecken (4,7) der Reihenschaltung (30) jeweils wenigstens zwei Lichtleitfasern (41,43 bzw. 71,73) und eine optische Steckverbindung (42 bzw. 72) zum lösbaren Verbinden der beiden Lichtleifasern (41,43 bzw. 71,73) umfassen.

**Claims**

1. Method for measuring an alternating magnetic field (**H**), in which

    a) two light signals (L1,L2) traverse an optical series circuit (30) comprising a first optical transmission link (4), a first polarizer (5), a sensor device (3) exhibiting the Faraday effect, a second polarizer (6) and a second optical transmission link (7) in mutually opposite directions,
    b) after the traversal of the optical series circuit (30) by the two light signals (L1, L2) their light intensities (I1, I2) are converted into electric intensity signals (S1, S2) proportional to said light intensities (I1, I2),
    c) there is formed in each case from the two electric intensity signals (S1, S2) a direct signal component (D1, D2) which is proportional to a direct light component ($I1_{DC}$, $I2_{DC}$) of the light intensity (I1, I2) of the respective light signal (L1, L2), the direct light components ($I1_{DC}$, $I2_{DC}$) containing no frequency components of the alternating magnetic field (**H**), and
    d) a measuring signal (M,M") which is virtually independent of changes in intensity in the optical series circuit (30) is formed for the alternating magnetic field (**H**) from the electric intensity signals (S1, S2) and their direct signal components (D1, D2).

2. Method according to Claim 1, in which the measuring signal (M) is proportional to the quotient

$$(I2_{DC} \cdot I1 - I1_{DC} \cdot I2) / (I2_{DC} \cdot I1 + I1_{DC} \cdot I2),$$

    I1 being the light intensity of a first of the two light signals (L1), and $I1_{DC}$ being its direct component, and I2 being the light intensity of a second of the two light signals (L2) and $I2_{DC}$ being its direct component.

3. Method according to Claim 1, in which

    a) the direct component ($I1_{DC}$) of the light intensity (I1) of a first of the two light signals (L1) is multiplied by a correction factor and this correction factor is adapted until the difference between the direct component ($I1_{DC}$) multiplied by the correction factor and the direct component ($I2_{DC}$) of the light intensity (12) of the second light signal (12) lies within a prescribed tolerance range about zero, and
    b) a measuring signal (M") is formed which is proportional to the quotient of a difference between the light intensity (I1), multiplied by the said correction factor, of the first light signal (L1) and the light intensity (I2) of the second light signal (L2), and the sum of the light intensity (I1), multiplied by the said correction factor, of the first light signal (L1) and the light intensity (12) of the second light signal (L2).

4. Method according to one of Claims 1 to 3, in which the polarization axes of the two polarizers (5,6) are rotated with respect to one another by an angle ($\alpha$) of at least approximately $\pm 45°$.

5. Method according to one of the preceding claims, in which the alternating magnetic field (**H**) of an alternating electric current (I) is measured and the measuring signal (M,M") is used as a measure of the alternating electric current (I).

6. Arrangement for measuring an alternating magnetic field (**H**), having

    a) an optical series circuit (30) comprising a first optical transmission link (4), a first polarizer (5), a sensor device (3) exhibiting the Faraday effect, a second polarizer (6) and a second optical transmission link (7),

b) means (10,11,12,13) for transmitting two light signals (L1,L2) through the optical series circuit (30) in mutually opposite directions,

c) means (21, 22) for converting light intensities (I1, I2) of the two light signals (L1, L2) after their traversal of the optical series circuit (30) into electric intensity signals (S1, S2) proportional to said light intensities (I1, I2),

d) means (28, 29) for forming in each case one direct signal component (D1, D2) from the two electric intensity signals (S1, S2), the respective direct signal component (D1, D2) being proportional to a direct light component ($I1_{DC}$, $I2_{DC}$) of the light intensity (I1, I2) of the respective light signal (L1, L2), and direct light components ($I1_{DC}$, $I2_{DC}$) containing no frequency components of the alternating magnetic field (**H**), and

e) Means (23, 24, 25, 26, 27, 31, 32, 33, 34, 35, 36) for forming a measuring signal (M,M"), virtually independent of changes in intensity in the optical series circuit (30), for the alternating magnetic field (**H**) from the electric intensity signals (S1, S2) and their direct signal components (D1, D2).

**7.** Arrangement according to Claim 6, in which the measuring signal (M) is proportional to the quotient

$$(I2_{DC} \cdot I1 - I1_{DC} \cdot I2) / (I2_{DC} \cdot I1 + I1_{DC} \cdot I2),$$

I1 being the light intensity of a first of the two light signals (L1), and $I1_{DC}$ being its direct component, and I2 being the light intensity of a second of the two light signals (L2) and $I2_{DC}$ being its direct component.

**8.** Arrangement according to Claim 6, in which in the evaluation unit (20)

a) a controller (33) is provided for controlling the difference between the direct component ($I1_{DC}$), multiplied by a correction factor, of the light intensity (I1) of a first of the two light signals (L1) and the direct component ($I2_{DC}$) of the light intensity (I2) of the second light signal (L2) to the desired value of zero by setting the correction factor, and further

b) means (34,35,36) are provided for forming a measuring signal (M") which is proportional to the quotient of a difference between the light intensity (I1), multiplied by the said correction factor, of the first light signal (L1) and the light intensity (I2) of the second light signal (L2), and the sum of the light intensity (I1), multiplied by the said correction factor, of the first light signal (L1) and the light intensity (I2) of the second light signal (L2).

**9.** Arrangement according to one of Claims 6 to 8, in which the polarization axes of the two polarizers (5,6) are rotated with respect to one another by an angle ($\alpha$) of at least approximately $\pm$ 45°.

**10.** Arrangement according to one of Claims 6 to 9, in which the sensor device (3) is arranged in the alternating magnetic field (**H**) of an alternating electric current (I), and the evaluating means (20) derive the measuring signal (M) as a measure of the alternating electric current (I).

**11.** Arrangement according to one of Claims 6 to 10, in which the two optical transmission links (4,7) of the series circuit (30) comprise optical fibres.

**12.** Arrangement according to Claim 11, in which the two optical transmission links (4,7) of the series circuit (30) respectively comprise at least two optical fibres (41,43 or 71,73) and an optical multiple connection (42 or 72) for detachably connecting the two optical fibres (41,43 or 71,73).

**Revendications**

**1.** Procédé pour mesurer un champ magnétique alternatif (H), dans lequel

a) deux signaux lumineux (L1, L2) passent en sens inverse dans un circuit série optique (30) composé d'une première voie de transmission optique (4), d'un premier polarisateur (5) d'un dispositif capteur (3) présentant l'effet Faraday, d'un deuxième polarisateur (6) et d'une deuxième voie de transmission optique (7),

b) on convertit les intensités lumineuses (I1, I2) des deux signaux lumineux (L1, L2) après leur passage dans le circuit série optique (30) en signaux d'intensités électriques (SI, S2) proportionnels à ces intensités lumineuses (I1, I2),

c) on forme à partir des deux signaux d'intensités électriques (S1, S2) à chaque fois une composante de signal continue (D1, D2) qui est proportionnelle à une composante de lumière continue ($I1_{DC}$, $I2_{DC}$) de l'intensité lumineuse (I1, I2) du signal lumineux respectif (L1, L2), les composantes de lumière continues (I1$_{DC}$, I2$_{DC}$) ne contenant aucune composante fréquentielle du champ magnétique alternatif (H), et

d) on forme à partir des signaux d'intensités électriques (S1, S2) et de leurs composantes de signal continues (D1, D2) un signal de mesure (M, M'') pratiquement indépendant de variations d'intensité dans le circuit série optique (30) pour le champ magnétique alternatif (H).

**2.** Procédé selon la revendication 1, dans lequel le signal de mesure (M) est proportionnel au quotient

$$(I2_{DC} \cdot I1 - I1_{DC} \cdot I2) / (I2_{DC} \cdot I1 + I1_{DC} \cdot I2)$$

Il étant l'intensité lumineuse d'un premier signal (L1) parmi les deux signaux lumineux, I1$_{DC}$ étant sa composante continue, I2 étant l'intensité lumineuse d'un deuxième signal (L2) parmi les deux signaux lumineux et I2$_{DC}$ étant sa composante continue.

**3.** Procédé selon la revendication 1, dans lequel

a) on multiplie la composante continue (I1$_{DC}$) de l'intensité lumineuse (I1) d'un premier signal lumineux (L1) par un facteur de correction et on adapte ce facteur de correction jusqu'à ce que la différence entre la composante continue (I1$_{DC}$) multipliée par le facteur de correction et la composante continue (I2$_{DC}$) de l'intensité lumineuse (I2) du deuxième signal lumineux (L2) se trouve à l'intérieur d'un domaine de tolérance prescrit autour de zéro,

b) on forme un signal de mesure (M'') proportionnel au quotient formé à partir d'une différence de l'intensité lumineuse (I1), multipliée par ledit facteur de correction, du premier signal lumineux (L1) et de l'intensité lumineuse (I2) du deuxième signal lumineux (L2) et à partir de la somme de l'intensité lumineuse (I1), multipliée par ledit facteur de correction, du premier signal lumineux (L1) et de l'intensité lumineuse (I2) du deuxième signal lumineux (L2).

**4.** Procédé selon l'une des revendications 1 à 3, dans lequel les axes de polarisation des deux polarisateurs (5, 6) sont tournés l'un par rapport à l'autre d'un angle (a) égal au moins approximativement à $\pm$ 45°.

**5.** Procédé selon l'une des revendications précédentes, dans lequel on mesure le champ magnétique alternatif (H) d'un courant électrique alternatif (I) et on exploite le signal de mesure (M, M'') comme mesure pour le courant électrique alternatif (I).

**6.** Dispositif pour mesurer un champ magnétique alternatif (H), comportant

a) un circuit série optique (30) composé d'une première voie de transmission optique (4), d'un premier polarisateur (5) d'un dispositif capteur (3) présentant l'effet Faraday, d'un deuxième polarisateur (6) et d'une deuxième voie de transmission optique (7),

b) des moyens (10, 11, 12, 13) pour l'émission, en sens inverse, de deux signaux lumineux (L1, L2) à travers le circuit série optique (30),

c) des moyens (21, 22) pour la conversion d'intensités lumineuses (I1, I2) des deux signaux lumineux (L1, L2) après leur passage dans le circuit série optique (30) en des signaux d'intensités électriques (S1, S2) proportionnels à ces intensités lumineuses (I1, I2),

d) des moyens (28, 29) pour la formation à chaque fois d'une composante de signal continue (D1, D2) à partir des deux signaux d'intensités électriques (S1, S2), la composante de signal continue respective (D1, D2) étant proportionnelle à une composante de lumière continue (I1$_{DC}$, I2$_{DC}$) de l'intensité lumineuse (I1, I2) du signal lumineux (L1, L2) respectif et les composantes de lumière continues (I1$_{DC}$, I2$_{DC}$) ne contenant aucune composante fréquentielle du champ magnétique alternatif (H), et

e) des moyens (23, 24, 25, 26, 27, 31, 32, 33, 34, 35, 36) pour la formation d'un signal de mesure (M, M'') pratiquement indépendant des variations d'intensité dans le circuit série optique (30) pour le champ magnétique alternatif (H) à partir des signaux d'intensités électriques (S1, S2) et de leurs composantes de signal continues (D1, D2).

**7.** Dispositif selon la revendication 6, dans lequel le signal de mesure (M) est proportionnel au quotient (I2$_{DC}$ · I1 - I1$_{DC}$ · I2) / (I2$_{DC}$ · I1 + I1$_{DC}$ · I2) Il étant l'intensité lumineuse d'un premier signal (L1) parmi les deux signaux lumineux, I1$_{DC}$ étant sa composante continue, I2 étant l'intensité lumineuse d'un deuxième signal (L2) parmi les deux signaux lumineux et $I2_{DC}$ étant sa composante continue.

8. Dispositif selon la revendication 6, dans lequel l'unité d'évaluation (20) comporte

a) un régulateur (33) pour réguler sur la valeur de consigne zéro, par réglage du facteur de correction, la différence entre la composante continue ($I1_{DC}$), multipliée par un facteur de correction, de l'intensité lumineuse (Il) d'un premier signal lumineux (L1) et la composante continue ($I2_{DC}$) de l'intensité lumineuse (I2) du deuxième signal lumineux (L2) et, de plus,

b) des moyens (34, 35, 36) pour la formation d'un signal de mesure (M") proportionnel au quotient formé à partir d'une différence de l'intensité lumineuse (I1), multipliée par ledit facteur de correction, du premier signal lumineux (L1) et de l'intensité lumineuse (I2) du deuxième signal lumineux (L2) et à partir de la somme de l'intensité lumineuse (I1), multipliée par ledit facteur de correction, du premier signal lumineux (L1) et de l'intensité lumineuse (I2) du deuxième signal lumineux (L2).

9. Dispositif selon l'une des revendications 6 à 8, dans lequel les axes de polarisation des deux polarisateurs (5, 6) font l'un par rapport à l'autre un angle ($\alpha$) égal au moins approximativement à $\pm\,45°$.

10. Dispositif selon l'une des revendications 6 à 9, dans lequel le dispositif capteur (3) est agencé dans le champ magnétique alternatif (H) d'un courant électrique alternatif (I) et dans lequel les moyens d'évaluation (20) déduisent le signal de mesure (M) comme mesure pour le courant électrique alternatif (I).

11. Dispositif selon l'une des revendications 6 à 10, dans lequel les deux voies de transmission optiques (4, 7) du circuit série (30) comprennent des fibres optiques.

12. Dispositif selon la revendication 11, dans lequel les deux voies de transmission optiques (4, 7) du circuit série (30) comprennent chacune au moins deux fibres optiques (41, 43 et 71, 73) et une connexion à fiche optique (42 et 72) pour la connexion amovible des deux fibres optiques (41, 43 et 71, 73).

$$M = \frac{D2 \cdot S1 - D1 \cdot S2}{D2 \cdot S1 + D1 \cdot S2}$$

FIG 1

$$M'' = \frac{S1-S2}{S1+S2}$$

FIG 2